**Europäisches Patentamt**

**European Patent Office**

**Office européen des brevets**

(19)

(11) Veröffentlichungsnummer: **0 054 648**
A2

# (12) EUROPÄISCHE PATENTANMELDUNG

(21) Anmeldenummer: 81108242.9

(22) Anmeldetag: 12.10.81

(51) Int. Cl.³: **H 01 L 29/91, H 01 L 21/00**

(30) Priorität: 18.12.80 DE 3047870

(43) Veröffentlichungstag der Anmeldung: 30.06.82
Patentblatt 82/26

(84) Benannte Vertragsstaaten: **DE FR GB IT**

(71) Anmelder: **SIEMENS AKTIENGESELLSCHAFT** Berlin und München, Postfach 22 02 61, D-8000 München 22 (DE)

(72) Erfinder: **Müller, Jörg, Dr. Ing.,** Herzog-Tassilo-Ring 44, D-8011 Zorneding (DE)

(54) **pn-Diode und Verfahren zu deren Herstellung.**

(57) Die Erfindung betrifft eine pn-Diode, bei der auf einem Galliumarsenid- beziehungsweise Indiumphosphid-Substrat (2) oder auf ein ähnliches Substrat (2) aus binären, ternären oder quaternären Verbindungshalbleitern, die sich durch Ionenimplantation semiisolierend machen lassen, epitaktisch mindestens eine Schicht (3) abgeschieden ist, bestehend aus dem gleichen Halbleitermaterial wie das Substrat, und bei der in oder auf die epitaktisch abgeschiedene Schicht (2) p⁺-dotierte Bereiche (12) ein- oder aufgebracht sind und bei der in dieser epitaktisch abgeschiedenen Schicht (2) Isolatorbereiche (4) durch Wasserstoffimplantation eingebracht sind. Die Erfindung wird angewendet bei abrupten und hyperabrupten pn-Dioden.

ACTORUM AG

SIEMENS AKTIENGESELLSCHAFT
Berlin und München

0054648

Unser Zeichen
VPA 80 P 1 2 0 2 E

## pn-Diode und Verfahren zur deren Herstellung

Die Erfindung betrifft eine pn-Diode, bestehend aus Halbleitermaterial mit Isolatorschichten.

Es wurde bereits versucht, Isolatorschichten auf Oberflächenteile von pn-Dioden in der Weise aufzubringen, daß zum Beispiel Siliciumdioxid ($SiO_2$) oder Siliciumnitrid ($Si_3N_4$) oder Siliciumoxid (SiO) auf diesen Oberflächenteilen abgeschieden wurde. Eine derartige Isolatoranbringung ist jedoch mit Temperaturschritten verbunden. Temperaturschritte schaden andererseits den elektrischen Eigenschaften der pn-Diode. So können sich zum Beispiel andere Leitfähigkeiten durch Temperaturschritte einstellen in der Weise, daß n-leitendes Material in p-leitendes Material übergeht. Es kann nämlich beispielsweise bei der Verwendung von Galliumarsenid Arsen aus dem Halbleitermaterial ausdiffundieren. Ähnlich ist es bei der Verwendung von Indiumphosphid. Andererseits ist es jedoch wichtig, dicke Isolatorschichten auf pn-Dioden abzuscheiden, um unerwünschte Kapazitäten zwischen den Kontakten und darunterliegenden leitenden Halbleiterschichten möglichst gering zu halten.

Aufgabe der vorliegenden Erfindung ist es daher, eine pn-Diode anzugeben, deren elektrische Eigenschaften stabil sind und die zugleich eine kleine Kapazität zwischen den Kontakten und darunterliegenden Halbleiterschichten aufweist.

Diese Aufgabe wird bei einer pn-Diode dadurch gelöst, daß auf ein Galliumarsenid- beziehungsweise Indiumphos-

Kus 1 Dx / 12.12.1980

0054648

phid-Substrat oder auf ein ähnliches Substrat aus binären, ternären oder quaternären Verbindungshalbleitern, die sich durch Ionenimplantation semiisolierend machen lassen, epitaktisch mindestens eine Schicht, bestehend aus dem gleichen Halbleitermaterial wie das Substrat, abgeschieden ist und daß in oder auf die epitaktisch abgeschiedene Schicht $p^+$-dotierte Bereiche ein- oder aufgebracht sind, und daß in die epitaktisch abgeschiedene Schicht Isolatorbereiche durch Ionenimplantation, insbesondere durch Wasserstoffimplantation eingebracht sind.

Durch die Ionenimplantation, insbesondere die Wasserstoffimplantation der epitaktisch abgeschiedenen Schicht lassen sich relativ dicke Isolatorschichten einfach herstellen. Diese relativ dicken Isolatorschichten bewirken andererseits kleine Streukapazitäten hiernach gefertigter pn-Dioden, was vorteilhaft für die Kapazität derartiger Dioden ist. Außerdem bleiben in vorteilhafter Weise bei derartigen pn-Dioden die elektrischen Eigenschaften während der Herstellung erhalten.

Durch die Ionenimplantation, insbesondere die Wasserstoffimplantation, wird die Herstellung von erfindungsgemäßen pn-Dioden gegenüber der sonst üblichen Herstellung wesentlich vereinfacht. Außerdem ist bei erfindungsgemäßen pn-Dioden die mechanische Stabilität, insbesondere die Bruchfestigkeit, wesentlich höher als bei bisher bekannten pn-Dioden, zum Beispiel mit Mesastruktur.

Durch die Ionenimplantation sind Chips mit hiernach gefertigten pn-Dioden bereits ohne einen weiteren Aufwand passiviert, was wiederum eine Vereinfachung und Verbesserung hiernach gefertigter pn-Dioden bewirkt. Außerdem läßt sich durch die Passivierung der Einbau in herme-tisch abgeschlossene Gehäuse einsparen.

0054648

Es ist vorteilhaft, daß die Wasserstoffimplantation selbstjustierend erfolgt. Dadurch lassen sich besonders kleine Geometrien mit geringen parasitären Kapazitäten einfach erzeugen, eine Tatsache, die bei fortschreitender Technik immer größere Bedeutung gewinnt.

Es ist auch erfinderisch, daß die eingebrachten Isolatorbereiche eine Dicke aufweisen, die die Dicke der epitaktischen Schicht übertrifft und in das Substrat hineinreicht. Bei erfindungsgemäßen pn-Dioden mit relativ dünnen epitaktischen Schichten ist es vorteilhaft, die Isolatorschicht bis in das Substrat heineinreichen zu lassen, weil dadurch die Streukapazitäten vorteilhaft klein gehalten werden können.

Es ist auch erfinderisch, daß die Dicke der eingebrachten Isolatorbereiche geringer ist als die Dicke der epitaktisch abgeschiedenen Schicht. Bei relativ dicken epitaktischen Schichten an erfindungsgemäßen pn-Dioden läßt sich die Dicke der eingebrachten Isolatorbereiche nicht beliebig vergrößern, so daß diese gegebenenfalls nicht in die Substratschicht hineinragt. Die Dicke einer implantierten Schicht ist bekanntlich durch die vorgegebene maximale Teilchenenergie beschränkt. Die absolute Dicke der Isolatorbereiche ist jedoch auch in diesen Fällen so groß, daß Streukapazitäten minimiert werden können.

Es ist auch vorteilhaft, daß an elektrisch leitenden Bereichen der epitaktisch abgeschiedenen Schicht ein erster Kontakt vorgesehen ist, der auch Teile der ionenimplantierten Isolatorschicht überlagert. Durch diese Maßnahme läßt sich eine bessere Haftfestigkeit des Kontaktierflecks bewirken. Die dadurch gleichzeitig entstehenden Streukapazitäten sind wegen der Dicke der darunterliegenden Isolatorschicht entsprechend klein.

0054648

Es ist auch vorteilhaft, daß ein zweiter Kontakt am Substrat vorgesehen ist, der wahlweise von der gleichen Oberfläche her angebracht ist wie der erste Kontakt oder an derjenigen Substratoberfläche angebracht ist, die der Grenzfläche zur epitaktischen Schicht gegenüberliegt. Bei erfindungsgemäßen pn-Dioden lassen sich dadurch zwei verschiedene Kontaktiermethoden anwenden, die je nach Bedarf in vorteilhafter Weise angewendet werden können.

Es ist auch erfinderisch, daß ein zum Beispiel $n^+$-dotiertes Substrat, bestehend aus Galliumarsenid oder Indiumphosphid, oder aus einem ähnlichen Substrat aus binären, ternären oder quaternären Verbindungshalbleitern, die sich durch Ionenimplantation semiisolierend machen lassen, einseitig mit einer zum Beispiel n-dotierten epitaktisch abgeschiedenen Schicht versehen wird,
daß in oder auf die n-dotierte epitaktisch aufgebrachte Schicht $p^+$-dotierte Bereiche ein- oder aufgebracht sind,
daß danach ganzflächig eine Passivierungsschicht, zum Beispiel bestehend aus Siliciumoxid (SiO) und/oder Siliciumdioxid ($SiO_2$) und/oder Siliciumnitrid ($Si_3N_4$), abgeschieden wird,
daß an denjenigen Stellen der epitaktisch abgeschiedenen Schicht, an denen durch diese Schicht durchgeätzte Substratkontakte entstehen sollen, mittels photolithographischer Verfahren die Passivierungsschicht und die epitaktisch abgeschiedene Schicht weggeätzt werden,
daß an den Stellen der $p^+$-dotierten Bereiche, zum Beispiel mittels photolithographischer Verfahren, die Passivierungsschicht abgeätzt wird,
daß danach eine ganzflächige erste Kontaktabscheidung an der Oberfläche der epitaktisch abgeschiedenen Schicht und gegebenenfalls auch an der Substratrückseite erfolgt,
daß anschließend mittels photolithographischer Verfahren die auf der epitaktischen Schicht abgeschiedene Kontaktschicht als Implantationsmaske strukturiert wird,
daß selbstjustierend zu dieser Maske eine Ionenimplantation, insbesondere eine Wasserstoffimplantation durchgeführt wird,
daß aus dieser Maske gegebenenfalls diejenigen Teile
weggeätzt werden, die Kontakte an den pn-dotierten Bereichen und Substratkontakte elektrisch leitend verbinden,
daß die verbliebenen Maskenteile als Kontakte an den
$p^+$-dotierten Bereichen und gegebenenfalls als Substratkontakte dienen, die mittels einer zweiten Kontaktabscheidung verstärkt werden, und daß zur ersten Kontaktabscheidung eines oder mehrere der Metalle Titan (Ti),
Platin (Pt), Gold (Au) dienen.

Alle Temperaturschritte, wie beispielsweise eine ganzflächige Kontaktabscheidung auf der äußeren Substratoberfläche, werden im allgemeinen vor der selbstjustierenden Wasserstoffimplantation durchgeführt. Temperaturschritte setzen nämlich in unerwünschter Weise die Leitfähigkeit der implantierten Isolatorbereiche herauf,
weil dadurch die durch die Implantation erzeugten Kristallfehler zu einem Teil wieder ausgeheilt werden.

Nachfolgend wird die Erfindung an einem Ausführungsbeispiel und der Zeichnung näher erläutert. Es zeigen:

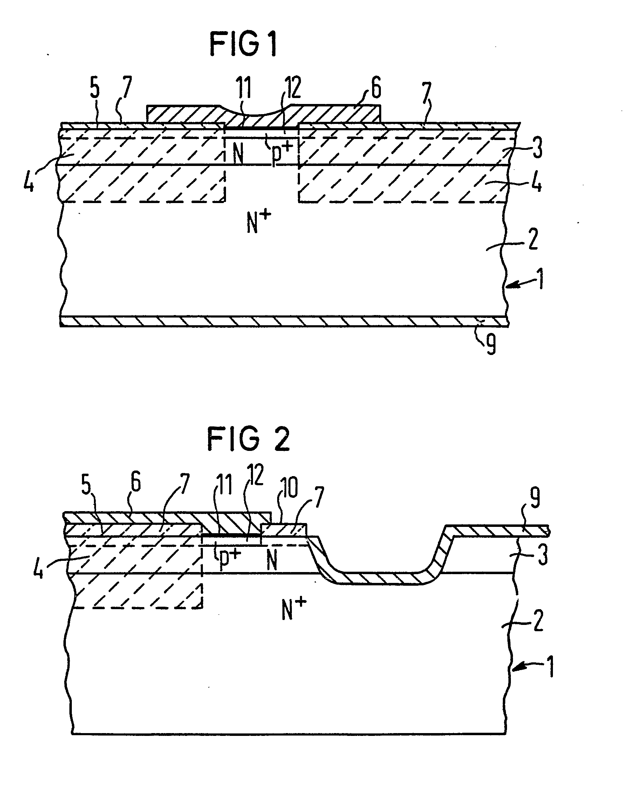

Fig. 1 und 2 zwei Ausführungsbeispiele mit unterschiedlicher Kontaktierung des Substrats.

Fig. 1 zeigt eine pn-Diode 1, bei der ein Substrat 2,
zum Beispiel bestehend aus $n^+$-dotiertem Galliumarsenid
(GaAs) oder Indiumphosphid (InP) oder aus binären, ternären oder quaternären Verbindungshalbleitern, die sich
durch Ionenimplantation semiisolierend machen lassen,

0054648

mit einer epitaktisch abgeschiedenen Schicht 3 versehen ist, die zum Beispiel aus dem gleichen n-dotierten Halbleitermaterial besteht. In die epitaktisch abgeschiedene Schicht 3 und gegebenenfalls auch in das darunter liegende Substrat 2 sind Isolatorbereiche 4 mittels Ionenimplantation, zum Beispiel mittels Wasserstoffimplantation, eingebracht. Unterhalb der die epitaktische Schicht 3 kontaktierenden Kontakte 6 beziehungsweise 11 sind $p^+$-dotierte Bereiche 12 in die epitaktisch abgeschiedene Schicht 3 eingebracht. Die Oberfläche 5 der epitaktisch abgeschiedenen Schicht 3 ist bis auf diejenigen Stellen, an denen Kontakte angebracht sind, mit einer Passivierungsschicht 7 versehen. Die Passivierungsschicht 7 kann aus Siliciumdioxid ($SiO_2$) und/oder Siliciumoxid (SiO) und/oder Siliciumnitrid ($Si_3N_4$) bestehen. Auf der Oberfläche 5 der epitaktisch abgeschiedenen Schicht 3 sind oberhalb der $p^+$-dotierten Bereiche 12 gegebenenfalls Kontakte 11 abgeschieden. Das Anbringen der Kontakte 11 ist nicht zwingend. Über den Kontakten 11 sind weitere Kontakte 6 abgeschieden. Die Kontakte 6 überlagern teilweise auch Isolatorbereiche 4. Das Substrat 2 wird vom Kontakt 9 kontaktiert.

In der Fig. 2 sind gleiche Gegenstände aus Fig. 1 mit gleichen Bezugszeichen versehen, weshalb diese nicht eigens noch einmal erläutert werden.

Während bei Fig. 1 das Substrat 2 mittels einer ganzflächigen Rückseitenkontaktierung kontaktiert wird, ist in Fig. 2 das Substrat 2 durch Beam Leads, dargestellt durch den Kontakt 9, kontaktiert. Die Beam Leads sind an der gleichen Halbleiteroberfläche angebracht wie die Kontakte 6. Der Teil der Passivierungsschicht 7, der sich zwischen den Kontakten 11 und den Beam-Lead-Kontakten 9 befindet, ist mit 10 bezeichnet.

Zur Herstellung einer erfindungsgemäßen pn-Diode nach den Fig. 1 und 2 wird ein aus Galliumarsenid (GaAs) oder Indiumphosphid (InP) bestehendes Substrat oder ein ähnliches Substrat 2 aus binären, ternären oder quaternären Verbindungshalbleitern, die sich durch Ionenimplantation semiisolierend machen lassen, verwendet, das zum Beispiel $n^+$-dotiert ist und mit einer epitaktischen Schicht 3 des gleichen Halbleitermaterials, die zum Beispiel n-dotiert ist, versehen ist. In oder auf die epitaktisch abgeschiedene Schicht 3 werden an den Stellen, an denen Kontakte 11 beziehungsweise 6 aufgebracht werden sollen, $p^+$-dotierte Bereiche 12 erzeugt. Die Erzeugung der $p^+$-dotierten Bereiche 12 kann selektiv mittels Epitaxie, Diffusion oder Implantation erfolgen. In diesem Fall müssen alle Oberflächenbereiche der epitaktisch abgeschiedenen Schicht 3, an denen keine $p^+$-dotierten Bereiche entstehen sollen, mittels einer geeigneten Maske abgedeckt werden. Die Erzeugung der $p^+$-dotierten Bereiche 12 kann auch durch ganzflächige Epitaxie, Implantation oder Diffusion auf der epitaktisch abgeschiedenen Schicht 3 erfolgen. Im Fall von Fig. 1 werden alle Oberflächenbereiche mit Ausnahme der erwünschten $p^+$-dotierten Bereiche durch eine nachfolgende Wasserstoffimplantation in Isolatorbereiche verwandelt. Im Fall von Ausführungsformen nach Fig. 2 muß hingegen dafür gesorgt werden, daß unterhalb der Teile 10 der Passivierungsschicht 7 entweder keine $p^+$-dotierten Bereiche entstehen oder diese wieder beseitigt werden. Durch eine Maskierung der Teile 10 vor der $p^+$-Dotierung läßt sich die Entstehung unerwünschter $p^+$-dotierter Bereiche verhindern. Bereits erzeugte unerwünschte $p^+$-dotierte Bereiche können durch eine geeignete Maske bei der nachfolgenden Wasserstoffimplantation beseitigt werden. Eine hierfür geeignete Maske muß oberhalb der Teile 10 der Passivierungsschicht 7 eine solche Dicke aufweisen, daß

0054648

die Wasserstoffimplantation gerade die $p^+$-dotierten Bereiche durchsetzt, während die darunterliegenden Halbleiterbereiche von der Implantation nicht betroffen werden. Danach wird eine Passivierungsschicht 7, zum Beispiel bestehend aus Siliciumdioxid ($SiO_2$) und/oder Siliciumoxid ($SiO$) und/oder Siliciumnitrid ($Si_3N_4$), abgeschieden. Mittels eines photolithographischen Verfahrens werden alle diejenigen Oberflächenbereiche, die nicht der Wasserstoffimplantation ausgesetzt werden sollen, mit einem zum Beispiel metallischen Belag, zum Beispiel bestehend aus Titan (Ti) und/oder Platin (Pt) und/oder Gold (Au), versehen, dessen Dicke ausreicht, um eine Wasserstoffimplantation an den darunterliegenden Teilen zu verhindern. Dazu kann zunächst zum Beispiel die mit der Passivierungsschicht versehene Chip-Oberfläche mittels eines stark quellbaren Photolacks ganzflächig versehen werden. In zwei aufeinanderfolgenden Ätzschritten können danach zunächst die Passivierungsschicht und die epitaktisch abgeschiedene Schicht bis zum Substrat abgeätzt werden, wie das zum Beispiel bei der Beam-Lead-Kontaktierung nach Fig. 2 notwendig ist. Für pn-Dioden nach Fig. 2 wird anschließend ein weiterer Ätzprozeß durchgeführt, der lediglich die Passivierungsschicht an denjenigen Stellen entfernt, die mit Kontakten 11 zur Kontaktierung des $p^+$-Bereichs belegt werden.

Bei der Herstellung von pn-Dioden nach Fig. 1 entfällt der erste Ätzschritt und es werden vielmehr nur Anschlußbereiche zur Kontaktierung des $p^+$-Bereichs von der Passivierungsschicht freigeätzt. Anschließend erfolgt eine ganzflächige Metallisierung der Chip-Oberfläche. Danach läßt man die Photolackreste quellen, so daß die Metallisierung an den Rändern der Photolackschicht abreißt und mit dieser abgehoben werden kann. Mit der so erzeugten Metallmaske erfolgt anschließend die Wasserstoffimplantation. Im Fall von Fig. 1 kann die erzeugte Metallmaske anschließend als Kontakt an den p$^+$-dotierten Bereichen verwendet werden. Zur Verstärkung und Erzielung einer besseren Haftfähigkeit wird die anfängliche Kontaktschicht durch weitere Kontakte 6 verstärkt, die auch die Isolatorbereiche zum Teil überlagern können. Im Fall von Fig. 2 müssen aus der Implantationsmaske diejenigen Metallbereiche der Maske weggeätzt werden, die den Kontakt 11 mit dem Beam-Lead-Kontakt am Substrat elektrisch leitend verbinden. Das sind diejenigen Teile der Metallmaske, die die Teile 10 der Passivierungsschicht 7 überlagern. Bei pn-Dioden nach Fig. 2 werden anschließend die Kontakte 11 durch Kontakte 6 und die Beam-Lead-Anschlüsse durch Kontakte 9 verstärkt. Das Abscheiden der Kontaktschichten 11 ist bei der Kontaktierung von pn-Dioden keine zwingende Maßnahme. Sie ergibt sich jedoch bei dem verwendeten Herstellungsverfahren zwanglos. Das Anbringen der Kontaktschichten 11 hat den Vorteil einer guten Kontaktgabe zwischen den Kontakten 6 und den zu kontaktierenden Halbleiterbereichen.

Bei pn-Dioden mit relativ dünner epitaktisch abgeschiedener Schicht 3 ragen die durch Wasserstoffimplantation gebildeten Isolatorbereiche 4 bis in das Substrat 2 hinein, während bei relativ dicken epitaktischen Schichten 3 die Isolatorbereiche 4 nur Teile der epitaktisch abgeschiedenen Schicht durchsetzen.

Eine Rückseitenkontaktierung nach Fig. 1 erfolgt vorteilhaft vor der Wasserstoffimplantation.

Erfindungsgemäße pn-Dioden können sowohl abrupte als auch hyperabrupte pn-Dioden darstellen.

2 Figuren

8 Patentansprüche

0054648

## Patentansprüche

1. pn-Diode, bestehend aus Halbleitermaterial mit Isolatorschichten, d a d u r c h   g e k e n n z e i c h - n e t ,   daß auf ein Galliumarsenid- beziehungsweise Indiumphosphid-Substrat oder auf ein ähnliches Substrat aus binären, ternären oder quaternären Verbindungshalbleitern, die sich durch Ionenimplantation semiisolierend machen lassen, epitaktisch mindestens eine Schicht, bestehend aus dem gleichen Halbleitermaterial wie das Substrat, abgeschieden ist und daß in oder auf die epitaktisch abgeschiedene Schicht $p^+$-dotierte Bereiche ein- oder aufgebracht sind, und daß in die epitaktisch abgeschiedene Schicht Isolatorbereiche durch Ionenimplantation, insbesondere durch Wasserstoffimplantation, eingebracht sind.

2. pn-Diode nach Anspruch 1, d a d u r c h   g e - k e n n z e i c h n e t ,   daß die Wasserstoffimplantation selbstjustierend erfolgt.

3. pn-Diode nach den Ansprüchen 1 und/oder 2, d a - d u r c h   g e k e n n z e i c h n e t ,   daß die eingebrachten Isolatorbereiche eine Dicke aufweisen, die die Dicke der epitaktischen Schicht übertrifft und in das Substrat hineinreicht.

4. pn-Diode nach Anspruch 1 und/oder 2, d a d u r c h   g e k e n n z e i c h n e t ,   daß die Dicke der eingebrachten Isolatorbereiche geringer ist als die Dicke der epitaktisch abgeschiedenen Schicht.

5. pn-Diode nach mindestens einem der Ansprüche 1 bis 4, d a d u r c h   g e k e n n z e i c h n e t ,   daß an elektrisch leitenden Bereichen der epitaktisch abgeschiedenen Schicht ein erster Kontakt vorgesehen ist,
der auch Teile der ionenimplantierten Isolatorschicht
überlagert.

6. pn-Diode nach mindestens einem der Ansprüche 1 bis 5,
d a d u r c h   g e k e n n z e i c h n e t ,   daß ein
zweiter Kontakt am Substrat vorgesehen ist, der wahlweise von der gleichen Oberfläche her angebracht ist wie
der erste Kontakt oder an derjenigen Substratoberfläche
angebracht ist, die der Grenzfläche zur epitaktischen
Schicht gegenüberliegt.

7. Verfahren zur Herstellung einer Schottky-Diode nach
mindestens einem der Ansprüche 1 bis 6,   d a d u r c h
g e k e n n z e i c h n e t ,   daß ein zum Beispiel
$n^+$-dotiertes Substrat, bestehend aus Galliumarsenid oder
Indiumphosphid, oder aus einem ähnlichen Substrat aus
binären, ternären oder quaternären Verbindungshalbleitern, die sich durch Ionenimplantation semiisolierend
machen lassen, einseitig mit einer zum Beispiel n-dotierten epitaktisch abgeschiedenen Schicht versehen
wird,
daß in oder auf die n-dotierte epitaktisch aufgebrachte
Schicht $p^+$-dotierte Bereiche ein- oder aufgebracht sind,
daß danach ganzflächig eine Passivierungsschicht, zum
Beispiel bestehend aus Siliciumoxid (SiO) und/oder Siliciumdioxid ($SiO_2$) und/oder Siliciumnitrid ($Si_3N_4$), abgeschieden wird,
daß an denjenigen Stellen der epitaktisch abgeschiedenen
Schicht, an denen durch diese Schicht durchgeätzte Substratkontakte entstehen sollen, mittels photolithographischer Verfahren die Passivierungsschicht und die epitaktisch abgeschiedene Schicht weggeätzt werden,
daß an den Stellen der $p^+$-dotierten Bereiche zum Beispiel mittels photolithographischer Verfahren die Passivierungsschicht abgeätzt wird, daß danach eine ganzflächige erste Kontaktabscheidung an der Oberfläche der epitaktisch abgeschiedenen Schicht und gegebenenfalls auch an der Substratrückseite erfolgt,

daß anschließend mittels photolitographischer Verfahren die auf der epitaktischen Schicht abgeschiedene Kontaktschicht als Implantationsmaske strukturiert wird, daß selbstjustierend zu dieser Maske eine Ionenimplantation, insbesondere eine Wasserstoffimplantation durchgeführt wird,

daß aus dieser Maske gegebenenfalls diejenigen Teile weggeätzt werden, die Kontakte an den $p^+$-dotierten Bereichen und Substratkontakte elektrisch leitend verbinden,

daß die verbliebenen Maskenteile als Kontakte an den $p^+$-dotierten Bereichen und gegebenenfalls als Substratkontakte dienen, die mittels einer zweiten Kontaktabscheidung verstärkt werden.

8. Verfahren nach Anspruch 7, d a d u r c h  g e - k e n n z e i c h n e t , daß zur ersten Kontaktabscheidung eines oder mehrere der Metalle Titan (Ti), Platin (Pt), Gold (Au) dienen.

1/1

0054648

FIG 1

FIG 2